# EUROPEAN PATENT APPLICATION

(11) **EP 4 730 973 A1**
(43) Date of publication of application: **22.04.2026**
(21) Application number: 23953675.8
(22) Date of filing: 28.09.2023
(51) Int. Cl.: H10K 59/126

(54) **DISPLAY PANEL AND MANUFACTURING METHOD THEREFOR, AND DISPLAY APPARATUS**

(71) Applicant: Boe Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Beijing 100176 (CN)
(72) Inventor: ZHANG, Wei, Beijing 100176 (CN); WU, Xintong, Beijing 100176 (CN); DONG, Xiangdan, Beijing 100176 (CN); WANG, Hongli, Beijing 100176 (CN)
(74) Representative: Brötz, Helmut
(86) International application number: PCT/CN2023/122623
(87) International publication number: WO 2025/065526

(57) **Abstract**

A display panel and a manufacturing method therefor, and a display apparatus. The display panel comprises: a first region; a second region; a third region; a plurality of sub-pixels; a base substrate; and an inorganic layer, a first partition structure, and a second partition structure which are located on the base substrate. The first partition structure comprises a first separation portion and a second separation portion which are stackedly arranged, and the first separation portion comprises a first protruding portion protruding relative to an edge of the second separation portion. The second partition structure comprises a first separation member and a second separation member which are stackedly arranged, and the first separation member comprises a second protruding portion protruding relative to at least part of an edge of the second separation member. The first partition structure and the second partition structure are both configured to partition at least one layer of light-emitting functional layers, at least a portion of the inorganic layer located in the first region serves as the first separation portion, and at least a portion of the inorganic layer located in the third region serves as the first separation member. The first partition structure and the second partition structure of the display panel provided by the present disclosure have simple structures and are easy to manufacture.

## Description

### TECHNICAL FIELD

Embodiments of the present disclosure relate to a display panel and a manufacturing method thereof, and a display apparatus.

### BACKGROUND

Organic light-emitting diode (OLED) display products have advantages such as rich colors, fast response time, and foldability, and are gradually replacing liquid crystal displays (LCDs); and thus, the market has increasingly high requirements for lifespan, power consumption, and high brightness modes of the organic light-emitting diode (OLED) display products. An organic light-emitting diode display apparatus includes a tandem device; and at least one light-emitting layer and a charge generation layer is added to the tandem device, so that the lifespan and the brightness of the light-emitting device can be improved, and the power consumption can be reduced, so that the user's requirements for the lifespan and the power consumption of the display apparatus can be met.

### SUMMARY

Embodiments of the present disclosure provide a display panel and a manufacturing method thereof, and a display apparatus.

A display panel provided by an embodiment of the present disclosure includes: a first region, a second region, a third region, a plurality of sub-pixels, a base substrate, an inorganic layer located on the base substrate, a first partition structure, and a second partition structure, the first region is configured to display; the second region is configured to transmit light, the first region is located on at least one side of the second region; the third region is located between the first region and the second region; the plurality of sub-pixels are located in the first region, each sub-pixel of at least some sub-pixels includes a light-emitting functional layer, and the light-emitting functional layer includes a plurality of film layers; the first partition structure is located on the base substrate and located between adjacent sub-pixels in the first region, the first partition structure includes a first isolation portion and a second isolation portion stacked, the first isolation portion is located on a side of the second isolation portion that is away from the base substrate, and the first isolation portion includes a first protrusion portion that protrudes relative to an edge of the second isolation portion; the second partition structure is located on the base substrate and located in the third region, the second partition structure includes a first isolation member and a second isolation member stacked, the first isolation member is located on a side of the second isolation member that is away from the base substrate, and the first isolation member includes a second protrusion portion that protrudes relative to at least a portion of an edge of the second isolation member; the first partition structure and the second partition structure are both configured to partition at least one layer of the light-emitting functional layer, at least a portion of the inorganic layer that is located in the first region serves as the first isolation portion, and at least a portion of the inorganic layer that is located in the third region serves as the first isolation member.

For example, according to the display panel provided by the embodiment of the present disclosure, the display panel further includes an organic layer located on the base substrate, the inorganic layer is located on a side of the organic layer that is away from the base substrate, at least a portion of the organic layer that is located in the first region serves as the second isolation portion, and at least a portion of the organic layer that is located in the third region serves as at least a portion of the second isolation member.

For example, according to the display panel provided by the embodiment of the present disclosure, an orthogonal projection of the first protrusion portion of the first isolation portion on the base substrate has a shape of a first ring, an orthogonal projection of the second protrusion portion of the first isolation member on the base substrate has a shape of a second ring, and an average ring width of the first ring is smaller than an average ring width of the second ring.

For example, according to the display panel provided by the embodiment of the present disclosure, the average ring width of the second ring is 1.2 to 3 times the average ring width of the first ring.

For example, according to the display panel provided by the embodiment of the present disclosure, in a direction perpendicular to the base substrate, a thickness of the first isolation portion is basically equal to a thickness of the first isolation member.

For example, according to the display panel provided by the embodiment of the present disclosure, in a direction perpendicular to the base substrate, a maximum thickness of a portion of the organic layer that is located in the first region is larger than or equal to a maximum thickness of a portion of the organic layer that is located in the third region.

For example, according to the display panel provided by the embodiment of the present disclosure, an orthogonal projection of the first isolation member of the second partition structure on the base substrate falls into an orthogonal projection of the second isolation member of the second partition structure on the base substrate.

For example, according to the display panel provided by the embodiment of the present disclosure, the second isolation member includes a first sub-isolation portion and a second sub-isolation portion, the first sub-isolation portion is located on a side of the second sub-isolation portion that is away from the base substrate, an edge of the first isolation member protrudes relative to an edge of the first sub-isolation portion, and an edge of the second sub-isolation portion protrudes relative to the edge of the first isolation member, or is flush with the edge of the first isolation member.

For example, according to the display panel provided by the embodiment of the present disclosure, the second isolation member includes at least one layer of metal structure, and the at least a portion of the organic layer that is located in the third region covers a surface of the at least one layer of metal structure.

For example, according to the display panel provided by the embodiment of the present disclosure, the at least one layer of metal structure includes a first metal structure and a second metal structure sequentially stacked in the direction perpendicular to the base substrate, the first metal structure is closer to the first isolation member than the second metal structure, and an edge of the second metal structure protrudes relative to an edge of the first metal structure.

For example, according to the display panel provided by the embodiment of the present disclosure, the first metal structure is in contact with the first isolation member, and an orthogonal projection of the first metal structure on the base substrate falls into an orthogonal projection of the first isolation member on the base substrate.

For example, according to the display panel provided by the embodiment of the present disclosure, a thickness of a portion of the organic layer that covers a surface of the first metal structure is smaller than a thickness of a portion of the organic layer that covers a surface of the second metal structure.

For example, according to the display panel provided by the embodiment of the present disclosure, the second isolation member further includes an insulation structure, the insulation structure is located between the first metal structure and the second metal structure, so that the first metal structure and the second metal structure are insulated from each other, and the insulation structure includes an inorganic material.

For example, according to the display panel provided by the embodiment of the present disclosure, in a direction perpendicular to the base substrate, a maximum thickness of the second isolation member is 1/3 to 1 of a maximum thickness of the portion of the organic layer that is located in the first region.

For example, according to the display panel provided by the embodiment of the present disclosure, the display panel further includes a pixel defining pattern, which is located in the first region and located on the base substrate; the pixel defining pattern comprising a plurality of first openings to define light-emitting regions of the at least some sub-pixels; the first partition structure is located between the light-emitting functional layer and the base substrate; and the first partition structure includes a portion surrounding a light-emitting region of each sub-pixel among the at least some sub-pixels; the pixel defining pattern further includes a second opening; a portion of at least one layer in the light-emitting functional layer that is located in the first opening is a continuous portion; at least a portion located in at least one second opening is partitioned; and a portion of the first partition structure that is exposed by the second opening is configured to partition the at least one layer of the light-emitting functional layer; each sub-pixel among the at least some sub-pixels further includes a first electrode and a second electrode located on both sides of the light-emitting functional layer in the direction perpendicular to the base substrate; the first electrode is located between the light-emitting functional layer and the base substrate, the pixel defining pattern is located on a side of the first electrode that is away from the base substrate; and the first partition structure is located between the first electrode and the base substrate; the display panel further includes a pixel circuit; the pixel circuit is located on a side of the first partition structure that is close to the base substrate; and the pixel circuit is electrically connected with the first electrode.

For example, according to the display panel provided by the embodiment of the present disclosure, the display panel further includes a data line and a gate line, which are located on the base substrate and located in the first region, the data line and the gate line are respectively electrically connected with the pixel circuit; the data line is configured to supply a data signal to the pixel circuit; and the gate line is configured to supply a scan signal to the pixel circuit; the first metal structure is arranged in a same layer as the data line; and the second metal structure is arranged in a same layer as the gate line.

For example, according to the display panel provided by the embodiment of the present disclosure, in the direction perpendicular to the base substrate, a thickness of the first sub-isolation portion is 1/4 to 1/3 of a thickness of the second sub-isolation portion.

At least one embodiment of the present disclosure further provides a display apparatus, which includes the display panel described in any one of the above.

At least one embodiment of the present disclosure further provides a manufacturing method of a display panel, the display panel includes a first region, a second region and a third region located between the first region and the second region; the first region is configured to display; the second region is configured to transmit light; and the first region is located on at least one side of the second region; the manufacturing method includes: forming an organic material layer on a base substrate, and patterning the organic material layer, to form an organic layer pattern in the third region; forming an inorganic material layer on the organic layer pattern, and patterning the inorganic material layer to form a first partition structure in the first region, and form a second partition structure in the third region; the first partition structure includes a first isolation portion and a second isolation portion stacked; the first isolation portion is located on a side of the second isolation portion that is away from the base substrate; the first isolation portion includes a first protrusion portion; the first protrusion portion protrudes relative to an edge of the second isolation portion; the second partition structure includes a first isolation member and a second isolation member stacked; the first isolation member is located on a side of the second isolation member that is away from the base substrate; the first isolation member includes a second protrusion portion; and the second protrusion portion protrudes relative to at least a portion of an edge of the second isolation member; both the first partition structure and the second partition structure are configured to partition at least one layer of the light-emitting functional layer; at least a portion of the inorganic material layer that is located in the first region is patterned to form the first isolation portion; and at least a portion of the inorganic material layer that is located in the third region is patterned to form the first isolation member.

For example, according to the manufacturing method of a display panel provided by the embodiment of the present disclosure, forming the inorganic material layer on the organic layer pattern, and patterning the inorganic material layer, to form the first partition structure in the first region, and form the second partition structure in the third region, includes: patterning the inorganic material layer, to form the first partition structure in the first region, and form an initial partition structure in the third region; the initial partition structure includes the first isolation member and a second initial isolation member; the first isolation member and the second initial isolation member are stacked, and an edge of the first isolation member protrudes relative to at least a portion of an edge of the second initial isolation member; and further etching the second initial isolation member in the third region, to form the second partition structure.

### BRIEF DESCRIPTION OF DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
Fig. 1 is a schematic plan view of a display panel provided by at least one embodiment of the present disclosure.
Fig. 2 is a partial cross-sectional schematic diagram sectioned along a line W1-W1' illustrated in Fig. 1.
Fig. 3 is a schematic diagram of another display panel provided by at least one embodiment of the present disclosure.
Fig. 4 is a schematic diagram of still another display panel provided by at least one embodiment of the present disclosure.
Fig. 5A is a schematic diagram of still another display panel provided by at least one embodiment of the present disclosure.
Fig. 5B is a schematic diagram of still another display panel provided by at least one embodiment of the present disclosure.
Fig. 6A is a schematic diagram of still another display panel provided by at least one embodiment of the present disclosure.
Fig. 6B is a schematic diagram of a light-emitting element having a Tandem structure.
Fig. 7 is a structural diagram of a first region of the display panel illustrated in Fig. 1 in an example.
Fig. 8 is a partially enlarged schematic diagram of an M region in Fig. 7.
Fig. 9 is a schematic block diagram of a display apparatus provided by at least one embodiment of the present disclosure.
Fig. 10 to Fig. 14 are flow charts of a manufacturing method of a display panel provided by an embodiment of the present disclosure.

### DETAILED DESCRIPTION

In order to make objects, technical details and advantages of the embodiments of the disclosure apparent, the technical solutions of the embodiment will be described in a clearly and fully understandable way in connection with the drawings related to the embodiments of the disclosure. It is obvious that the described embodiments are just a part but not all of the embodiments of the disclosure. Based on the described embodiments herein, those skilled in the art can obtain other embodiment(s), without any inventive work, which should be within the scope of the disclosure.

Unless otherwise specified, the technical terms or scientific terms used in the disclosure shall have normal meanings understood by those skilled in the art. The words "first", "second" and the like used in the disclosure do not indicate the sequence, the number or the importance but are only used for distinguishing different components. The word "comprise", "include" or the like only indicates that an element or a component before the word contains elements or components listed after the word and equivalents thereof, not excluding other elements or components.

As used in embodiments of the present disclosure, the features "parallel", "perpendicular", and "identical" etc. include the features "parallel", "perpendicular", and "identical," etc. in the strict sense, as well as "approximately parallel", "approximately perpendicular", and "approximately identical," etc., which include a certain amount of error, and are indicated to be within a range of acceptable deviations for a particular value as determined by a person of ordinary skill in the art, taking into account the measurement and the error associated with the measurement of the particular quantity (e.g., the limitation of the measurement system). For example, "approximately" can mean within one or more standard deviations, or within 10% or 5% of the stated value. Upon the quantity of a component being not specified in the following of the embodiment of the present disclosure, it means that the component can be one or more, or can be understood as at least one. "At least one" means one or more, and "a plurality of" means at least two.

In the present disclosure, the "arrangement in a same layer" refers to a structure formed of two (or more than two) types of structures by a same deposition process and patterned by a same patterning process, and their materials may be the same or different. In the present disclosure, the "integrated structure" refers to a structure formed of two (or more than two) types of structures that are connected with each other by a same deposition process and patterned by a same patterning process, and their materials may be the same or different.

Usually, a display panel having a "pinhole screen" usually includes a display region used for normal display and a hollow region used for arranging a sensor (e.g., a camera). The display region used for normal display usually includes a light-emitting element and a pixel circuit; the pixel circuit is electrically connected with the light-emitting element, and the pixel circuit is configured to drive the light-emitting element to emit light. The sensor is usually arranged in the hollow region; the hollow region is a region where a material is removed as compared with the normal display region, to facilitate the sensor to receive external ambient light. Therefore, the display panel having the "pinhole screen" is different from a display panel having a "full screen"; and the hollow region of the display panel having the "pinhole screen" has good transparency performance. Generally, the display panel further includes a third region located between the display region and the hollow region.

In study, an inventor of the present application finds that a Tandem device has characteristics of low power consumption and long lifespan. With respect to the Tandem device, a light-emitting functional layer in a light-emitting element may include a plurality of film layers stacked; however, there is a charge generation layer (CGL) arranged between at least two layers of the plurality of film layers in the Tandem device, and conductivity of the charge generation layer (CGL) is relatively great, so, upon the charge generation layer (CGL) being a whole-face film layer, the charge generation layer (CGL) of two adjacent light-emitting elements is a continuous film layer. Thus, a phenomenon of lateral migration of charges easily occurs, causing monochromatic chromaticity shift of the display panel in a low gray scale, which easily causes crosstalk between adjacent sub-pixels, leading to color cast of the display panel.

In order to reduce a risk of crosstalk between sub-pixels of different colors, it is necessary to partition at least one film layer in a light-emitting functional layer between sub-pixels of different colors; and in order to ensure a partition effect on film layers such as the light-emitting functional layer, it is necessary to further arrange a partition structure in a region close to an edge of the display region (e.g., the third region between the display region and the hollow region), to further partition the film layers such as the light-emitting functional layer in the edge region, so as to alleviate the crosstalk phenomenon, and ensure a display effect of sub-pixels in the display region. In some display panels, a partition structure located in the third region has a morphology and a structure different from a partition structure in the display region; for example, the partition structure located in the display region usually has a composite structure formed of an inorganic structural layer and an organic structural layer, while the partition structure in the third region usually has a multi-layer metal composite structure, for example, Ti/Al/Ti, etc.; so the partition structure in the third region usually requires different manufacturing processes, which makes the manufacturing process cumbersome and prone to process deviations. Therefore, overall uniformity of the partition structures in the display region and the third region needs to be improved.

At least one embodiment of the present disclosure provides a display panel and a manufacturing method thereof, and a display apparatus.

The display panel provided by the at least one embodiment of the present disclosure includes: a first region, a second region, a third region, a plurality of sub-pixels, a base substrate, as well as an inorganic layer located on the base substrate, a first partition structure and a second partition structure; the first region is configured to display, the second region is configured to transmit light, and the first region is located on at least one side of the second region; the third region is located between the first region and the second region; the plurality of sub-pixels are located in the first region, each sub-pixel among at least some sub-pixels includes a light-emitting functional layer, and the light-emitting functional layer includes a plurality of film layers; the first partition structure is located on the base substrate and is located between adjacent sub-pixels in the first region, the first partition structure includes a first isolation portion and a second isolation portion stacked, the first isolation portion is located on a side of the second isolation portion that is away from the base substrate, and the first isolation portion includes a first protrusion portion that protrudes relative to an edge of the second isolation portion; the second partition structure is located on the base substrate and is located in the third region, the second partition structure includes a first isolation member and a second isolation member stacked, the first isolation member is located on a side of the second isolation member that is away from the base substrate, and the first isolation member includes a second protrusion portion that protrudes relative to at least a portion of an edge of the second isolation member; the first partition structure and the second partition structure are both configured to partition at least one layer of the light-emitting functional layer, at least a portion of the inorganic layer that is located in the first region serves as the first isolation portion, and at least a portion of the inorganic layer that is located in the third region serves as the first isolation member.

In the display panel provided by the at least one embodiment of the present disclosure, the first isolation portion of the first partition structure located in the first display region and the first isolation member of the second partition structure located in the third region are arranged in a same layer, that is, formed by using a same deposition process and patterned by using a same patterning process, which is favorable for simplifying a manufacturing process of the first isolation portion and the first isolation member, so that structures of the first partition structure and the second partition structure are simplified and have good uniformity.

Hereinafter, the display panel and the manufacturing method thereof, and the display apparatus provided by the embodiments of the present disclosure will be described in conjunction with the accompanying drawings.

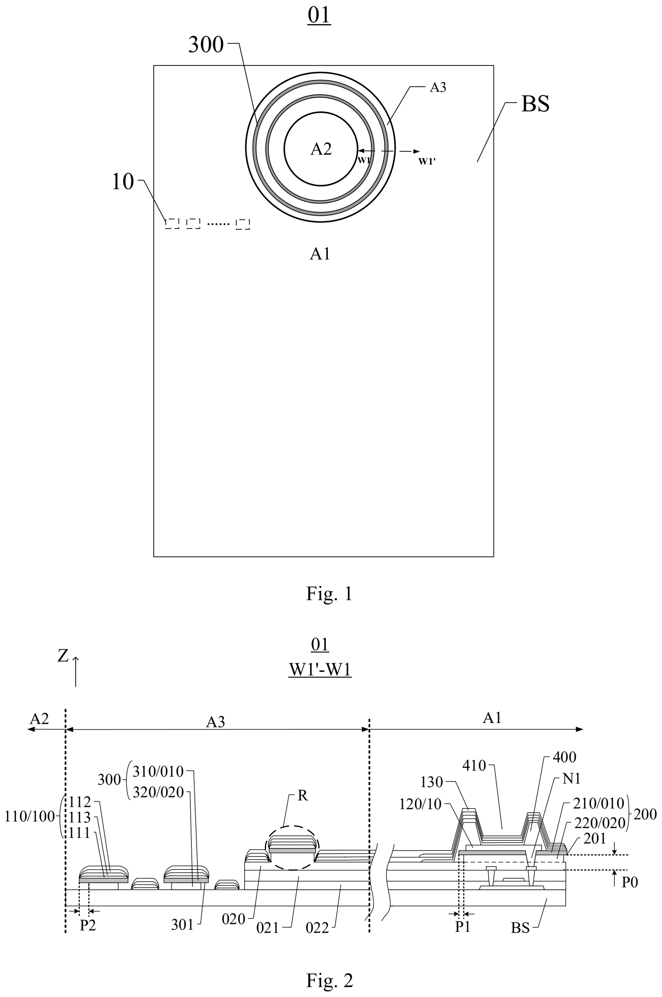

Fig. 1 is a schematic plan view of a display panel provided by at least one embodiment of the present disclosure; and Fig. 2 is a partial cross-sectional schematic diagram sectioned along a line W1-W1' illustrated in Fig. 1.

As illustrated in Fig. 1, a display panel 01 includes a first region A1, a second region A2 and a third region A3. The first region A1 is a display region and is configured to display. The second region A2 is a hollow region and is configured to transmit light, for example, a device such as a photosensitive sensor may be arranged in the second region A2. For example, the first region A1 may be located on at least one side of the second region A2. For example, in some embodiments, the first region A1 surrounds the second region A2, that is, the second region A2 may be surrounded by the first region A1. For example, the second region A2 may further be arranged in other position, which may be specifically determined according to needs. For example, the second region A2 may be located in a top center position of a base substrate BS.

For example, as illustrated in Fig. 1, the number of second regions A2 is equal to the number of third regions A3. For example, in some embodiments, the number of second regions A2 and the number of third regions A3 may be greater than 1. For example, the plurality of second regions A2 may be arranged in different positions or have different shapes according to design requirements. For example, the second region A2 may have a shape of a circle, an ellipse, or a polygon. For example, the second region A2 and the third region A3 may further have other shape, for example, a runway or a polygon, which will not be limited in the embodiments of the present disclosure.

For example, as illustrated in Fig. 1, the display panel 01 includes the base substrate BS and a plurality of sub-pixels 10 located on the base substrate BS. The plurality of sub-pixels 10 are located in the first region A1, so that the first region A1 serves as a display region. As illustrated in Fig. 1 and Fig. 2, each sub-pixel 10 among at least some sub-pixels 10 includes a light-emitting element 100; the light-emitting element 100 includes a light-emitting functional layer 110, as well as a first electrode 120 and a second electrode 130 located on both sides of the light-emitting functional layer 110 in a direction perpendicular to the base substrate BS (e.g., a Z direction illustrated in Fig. 2); and the first electrode 120 is located between the light-emitting functional layer 110 and the base substrate BS. For example, each sub-pixel 10 located in the first region A1 includes a light-emitting element 100, for example, the light-emitting element 100 may be an organic light-emitting element.

For example, as illustrated in Fig. 2, the light-emitting functional layer 110 in the light-emitting element 100 may include a first light-emitting layer (EML) 111, a charge generation layer (CGL) 113, and a second light-emitting layer (EML) 112 stacked; the charge generation layer 113 is located between the first light-emitting layer 111 and the second light-emitting layer 112. The charge generation layer 113 has strong conductivity, which may allow the light-emitting functional layer 110 to have advantages of long lifespan, low power consumption, and high brightness. For example, as compared with a light-emitting functional layer 110 without a charge generation layer 113, the light-emitting element 100 may have light-emitting brightness increased by nearly twice by arranging the charge generation layer 113 in the light-emitting functional layer 110. For example, the light-emitting element 100 of the sub-pixel 10 may be a tandem light-emitting element, for example, a Tandem OLED. For example, the first light-emitting layer 111 and the second light-emitting layer 112 may be structures obtained after patterning; and the charge generation layer 113 may be a structure arranged in a whole layer.

For example, as illustrated in Fig. 2, the charge generation layer 113 may include an N-type charge generation layer and a P-type charge generation layer. For example, in the respective sub-pixels 10, the light-emitting functional layer 110 may further include a hole injection layer (HIL), a hole transport layer (HTL), an electron transport layer (ETL) and an electron injection layer (EIL). For example, the hole injection layer (HIL), the hole transport layer (HTL), the electron transport layer (ETL), the electron injection layer (EIL), and the charge generation layer 113 are all shared film layers of the plurality of sub-pixels 10, and may be referred to as common layers.

For example, as illustrated in Fig. 2, the second light-emitting layer 112 may be located between the first light-emitting layer 111 and the second electrode 130; and the hole injection layer may be located between the first electrode 120 and the first light-emitting layer 111. For example, the electron transport layer may further be provided between the charge generation layer 113 and the first light-emitting layer 111. For example, the hole transport layer may be arranged between the second light-emitting layer 112 and the charge generation layer 113. For example, the electron transport layer and the electron injection layer may be provided between the second light-emitting layer 112 and the second electrode 130.

For example, the material of the electron transport layer may include aromatic heterocyclic compounds, for example, imidazole derivatives such as benzimidazole derivatives, imidazolium pyridine derivatives, benzimidazole phenanthridine derivatives, etc.; zine derivatives such as pyrimidine derivatives, triazine derivatives, etc.; compounds containing nitrogen-containing six-membered ring structures (also including compounds having substitution groups of phosphine oxide series on heterocycles) such as quinoline derivatives, isoquinoline derivatives, phenanthroline derivatives, etc. For example, as illustrated in Fig. 2, the charge generation layer 113 may be made of a material containing phosphorus oxide groups or a material containing triazine. For example, a ratio of electron mobility of the material of the charge generation layer 113 to electron mobility of the electron transport layer is 10⁻² to 10².

For example, as illustrated in Fig. 2, the first electrode 120 may be an anode; and the second electrode 130 may be a cathode. For example, the cathode may be made of a material with high conductivity and a low power function, for example, the cathode may be made of a metal material. For example, the anode may be made of a transparent conductive material having a high power function.

For example, as illustrated in Fig. 2, an orthogonal projection of the second electrodes 130 in at least some sub-pixels 10 on the base substrate BS is a whole-face structure. For example, the second electrode 130 may be a common electrode shared by a plurality of sub-pixels 10. For example, the second electrode 130 may be a common electrode shared by the above-described at least some sub-pixels 10.

For example, as illustrated in Fig. 2, an insulation layer 020 is provided between the first electrode 120 and the base substrate BS. For example, a film layer 021 and a film layer 022 are further provided between the insulation layer 020 and the base substrate BS, to play a role in insulation. In Fig. 2, some structures between the insulation layer 020 and the base substrate BS, for example, a film layer where signal lines such as data lines are located, as well as other insulation layers, are omitted.

As illustrated in Fig. 2, the display panel 01 further includes an inorganic layer 010 located on the base substrate BS. For example, the inorganic layer 010 is located on a side of the insulation layer 020 that is away from the base substrate BS and is in contact with the insulation layer 020.

As illustrated in Fig. 2, the display panel 01 further includes a first partition structure 200 and a second partition structure 300 located on the base substrate BS; the first partition structure 200 is located between adjacent sub-pixels 10 in the first region A1 and includes a first isolation portion 210 and a second isolation portion 220 stacked; the first isolation portion 210 is located on a side of the second isolation portion 220 that is away from the base substrate BS; and the first isolation portion 210 includes a first protrusion portion 201 that protrudes relative to an edge of the second isolation portion 220. The second partition structure 300 is located in the third region A3 and includes a first isolation member 310 and a second isolation member 320 stacked; the first isolation member 310 is located on a side of the second isolation member 320 that is away from the base substrate BS; and the first isolation member 310 includes a second protrusion portion 301 that protrudes relative to at least a portion of an edge of the second isolation member 320.

As illustrated in Fig. 2, both the first partition structure 200 and the second partition structure 300 are configured to partition at least one film layer of the light-emitting functional layer 100; for example, the first protrusion portion 201 of the first partition structure 200 may partition at least one film layer of the light-emitting functional layer 100, which thus may reduce a risk of crosstalk between adjacent sub-pixels 10. The second protrusion portion 301 of the second partition structure 300 may partition at least one film layer in the light-emitting functional layer 100, which thus may further reduce the risk of crosstalk.

As illustrated in Fig. 2, at least a portion of the inorganic layer 010 that is located in the first region A1 serves as the first isolation portion 210; and at least a portion of the inorganic layer 010 that is located in the third region A3 serves as the first isolation member 310. That is, the first isolation portion 210 and the first isolation member 310 are arranged in a same layer; and the first isolation portion 210 and the first isolation member 310 are formed by using a same deposition process and patterned by using a same patterning process; for example, the first isolation portion 210 and the first isolation member 310 are made of a same material. Thus, the first isolation portion 210 and the first isolation member 310 may be patterned with a same mask, which simplifies a manufacturing process, allows the first partition structure 200 and the second partition structure 300 to have a simple structure, and are easy to be manufactured and to control process deviations, so that the first partition structure 200 located in the first display region A1 and the second partition structure 300 located in the third region A3 have good uniformity in structure.

For example, as illustrated in Fig. 2, the display panel 01 further includes an organic layer 020 (that is, the above-described insulation layer 020) located on the base substrate BS; the inorganic layer 010 is located on a side of the organic layer 020 that is away from the base substrate BS; at least a portion of the organic layer 020 that is located in the first region A1 serves as the second isolation portion 220; and at least a portion of the organic layer 020 that is located in the third region A3 serves as at least a portion of the second isolation member 320.

For example, referring to Fig. 2, the second isolation portion 220 in the first partition structure 200 and the second isolation member 320 in the second partition structure 300 may also be arranged in a same layer, and the two may be formed by using a same deposition process and patterned by using a same patterning process; for example, the second isolation portion 220 and the second isolation member 320 are made of a same material. Therefore, the second isolation portion 220 and the second isolation member 320 may be patterned with a same mask, which simplifies the manufacturing process and makes it easy to control process deviations, so that the first partition structure 200 located in the first display region A1 and the second partition structure 300 located in the third region A3 have good uniformity in structure.

Of course, referring to Fig. 2, upon the light-emitting functional layer 110 that needs to be partitioned having different thicknesses, a thickness of the second isolation member 320 in a direction perpendicular to the base substrate BS may be set according to design requirements. For example, upon the light-emitting functional layer 110 that needs to be partitioned having a large thickness, the thickness of the second isolation member 320 may be correspondingly large to enhance partition capability of the second partition structure 300. For example, upon the light-emitting functional layer 110 that needs to be partitioned having a small thickness, the thickness of the second isolation member 320 may be small, as long as the second partition structure 300 plays a partition role thereof. For example, in some embodiments of the present disclosure, the first light-emitting layer 111 and the second light-emitting layer 112 may not be arranged in the third region A3, so that the second partition structure 300 may be used for partitioning at least one film layer in the light-emitting functional layer 110 except the first light-emitting layer 111 and the second light-emitting layer 112.

For example, as illustrated in Fig. 2, upon the light-emitting functional layer 110 having a small thickness, the thickness of the second isolation member 320 is smaller than the maximum thickness of the portion of the organic layer 020 that is located in the first region A1 in the direction perpendicular to the base substrate BS. For example, the thickness of the second isolation member 320 is smaller than the thickness of the second isolation portion 220, but it is not limited thereto. For example, upon the thickness of the second isolation member 320 being small, the second isolation member 320 may be a structure obtained by thinning at least a portion of the organic layer 020. For example, a half tone mask may be adopted to form the second isolation portion 220 located in the first region A1 and the second isolation member 320 located in the third region A3.

For example, as illustrated in Fig. 2, the number of second partition structures 300 may be 5 to 10, for example, may be 5 to 8, for example, 7 or 8, which will not be limited in the embodiments of the present disclosure.

For example, as illustrated in Fig. 2, the inorganic layer 010 may include an inorganic material, for example, silicon nitride, silicon oxide, or silicon oxynitride. For example, the organic layer 020 may include an organic material, for example, polyimide.

For example, as illustrated in Fig. 2, an orthogonal projection of the first protrusion portion 201 of the first isolation portion 210 on the base substrate BS has a shape of a first ring; an orthogonal projection of the second protrusion portion 301 of the first isolation member 310 on the base substrate BS has a shape of a second ring; and an average ring width P1 of the first ring is smaller than an average ring width P2 of the second ring. For example, the first partition structure 200 may form a "bottom cut" structure through the first protrusion portion 201 in the first isolation portion 210, to partition at least one film layer in the light-emitting functional layer 100, thereby reducing a risk of crosstalk between adjacent sub-pixels 10. For example, the second partition structure 300 may form a "bottom cut" structure through the second protrusion portion 301 in the first isolation member 310, to further play a partition role. By setting the average ring width P2 of the above-described second ring to be larger than the average ring width P1 of the above-described first ring, the second protrusion portion 301 of the first isolation member 310 may have a greater degree of protrusion relative to the second isolation member 320, so that the second partition structure 300 has stronger partition ability. For example, in the third region A3, the second partition structure 300 may partition all film layers of the light-emitting functional layer 100. For example, in the third region A3, the second partition structure 300 may partition all film layers of the light-emitting functional layer 100 and at a same time, partition the second electrode 130.

For example, as illustrated in Fig. 2, the average ring width of the above-described second ring is 1.2 to 3 times, for example, may be at least one of 1.2 to 1.5 times, 1.6 to 1.8 times, 1.7 to 2 times, 2.2 to 2.5 times, and 2.6 to 3 times; for example, may be 1.5 times, 1.8 times, 2 times, 2.5 times, 2.8 times, or 3 times the average ring width of the above-described first ring, which will not be limited in the embodiments of the present disclosure.

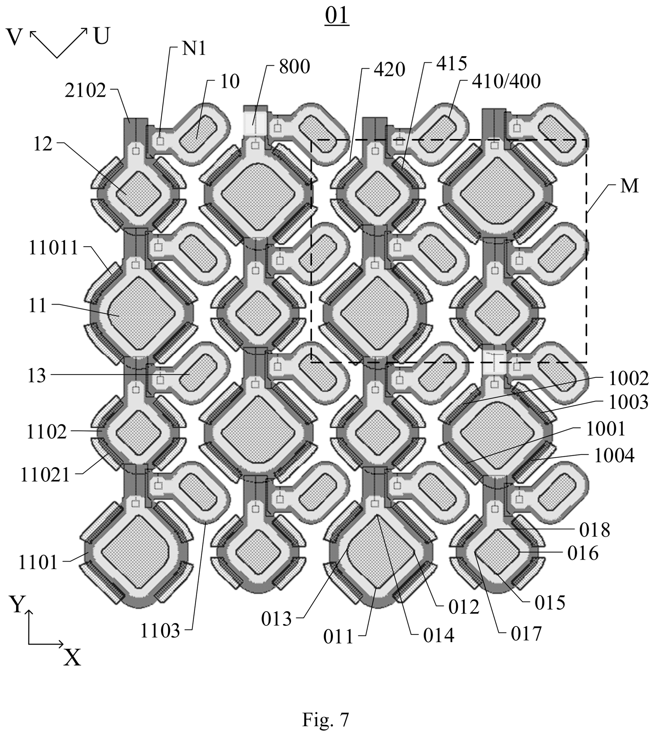

For example, as illustrated in Fig. 2 (and as illustrated in Fig. 7 below), the first ring corresponding to the first protrusion portion 201 in the first partition structure 200 surrounds a light-emitting region of a sub-pixel 10; and the second ring corresponding to the second protrusion portion 301 in the second partition structure 300 surrounds the second region A2, that is, a non-display region. For example, the above-described first ring is a non-closed ring, and the above-described second ring is a closed ring. For example, the above-described first ring and the above-described second ring may have substantially a same shape, or have different shapes. For example, the above-described first ring may be a circular ring or a rectangular ring having rounded corners. For example, the above-described second ring may be a circular ring or a rectangular ring having rounded corners.

For example, as illustrated in Fig. 2 (and as illustrated in Fig. 7 below), an outer circumference of the first ring corresponding to the first protrusion portion 201 in the first partition structure 200 is 10 microns to 90 microns, for example, may be at least one of 10 microns to 20 microns, 25 microns to 35 microns, 40 microns to 50 microns, 55 microns to 65 microns, 70 microns to 80 microns, 75 microns to 85 microns, and 80 microns to 90 microns, but it is not limited thereto. For example, an outer circumference of the second ring corresponding to the second protrusion portion 301 in the second partition structure 300 is 100 microns to 800 microns, for example, may be at least one of 100 microns to 300 microns, 200 microns to 400 microns, 350 microns to 450 microns, 450 microns to 600 microns, 500 microns to 650 microns, and 700 microns to 800 microns, which will not be limited in the embodiments of the present disclosure.

For example, as illustrated in Fig. 2 (and as illustrated in Fig. 7 below), a light-emitting region of one sub-pixel 10 may be surrounded by one continuous first ring as described above. For example, one first ring surrounding a light-emitting region of one sub-pixel 10 may also include a plurality of first sub-rings, and the plurality of first sub-rings are spaced apart. For example, the plurality of first sub-rings surrounding a light-emitting region of a same sub-pixel 10 may have substantially the same shape, or may have different shapes. For example, outer circumferences of the plurality of first sub-rings surrounding a light-emitting region of a same sub-pixel 10 may be unequal to each other, which will not be limited in the embodiments of the present disclosure.

For example, as illustrated in Fig. 1 and Fig. 2, the number of second rings surrounding the third region A3 may be 1 to 5, for example, may be at least one of 1 to 3, 2 to 4, 3 to 5, 1 to 4, and 4 to 5. For example, upon there being a plurality of second rings surrounding the third region A3, the plurality of second rings may have substantially the same shape, for example, may all have a shape of at least one of a circle, an ellipse, and a rectangle having rounded corners, which will not be limited in the embodiments of the present disclosure.

For example, as illustrated in Fig. 2, in the direction perpendicular to the base substrate BS, the thickness of the first isolation portion 210 is basically equal to the thickness of the first isolation member 310; that is, in a process of forming the first isolation portion 210 and the first isolation member 310, the inorganic layer 010 does not undergo local thinning treatment, and the thickness thereof is basically uniform, so that the first isolation portion 210 and the first isolation member 310 are arranged in a same layer. The above-described "basically equal" may refer to that the thicknesses of the two are equal to each other, or a ratio of a difference in thickness between the two to a thickness of one of the two is no more than 3%.

For example, as illustrated in Fig. 2, in the direction perpendicular to the base substrate BS, the maximum thickness of the portion of the organic layer 020 that is located in the first region A1 is larger than or equal to the maximum thickness of the portion of the organic layer 020 that is located in the third region A3. For example, the maximum thickness of the portion of the organic layer 020 that is located in the first region A1 is size P0 illustrated in Fig. 2. For example, the maximum thickness of the portion of the organic layer 020 that is located in the third region A3 is the thickness of the second isolation member 320.

For example, as illustrated in Fig. 2, the maximum thickness of the portion of the organic layer 020 that is located in the first region A1 is 3 microns to 5 microns, for example, may be at least one of 3 microns to 3.5 microns, 3.5 microns to 4 microns, 4 microns to 4.5 microns, and 4.5 microns to 5 microns. For example, the maximum thickness of the portion of the organic layer 020 that is located in the third region A3 is 0.5 microns to 1.5 microns, for example, may be at least one of 0.5 microns to 0.8 microns, 1.0 microns to 1.2 microns, and 1.3 microns to 1.5 microns.

For example, as illustrated in Fig. 2, a third partition structure R is further provided in the third region A3; and the third partition structure R is also configured to partition at least one layer in the light-emitting functional layer 110. For example, an orthogonal projection of the third partition structure R on the base substrate BS has a shape of a closed ring. For example, the number of third partition structures R may be 1 to 5, for example, may be at least one of 2 to 4, 3 to 5, and 1 to 2, which will not be limited in the embodiments of the present disclosure.

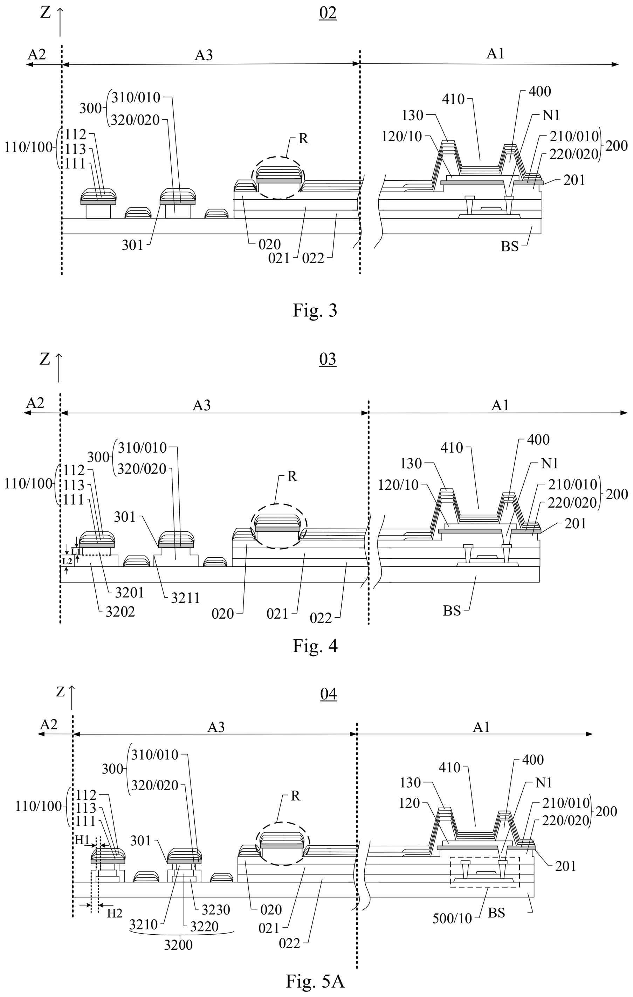

It should be noted that the accompanying drawings of the embodiment of the present disclosure are only exemplary illustrations of the film layer structures included in the first partition structure 200, the second partition structure 300 and the third partition structure R, and are not limitative. For example, the display panel according to the embodiment of the present disclosure may have other structures between the first partition structure 200 and the third partition structure R, and may also have other structures between the second partition structure 300 and the third partition structure R, which will not be limited in the embodiments of the present disclosure. Fig. 3 is a schematic diagram of another display panel provided by at least one embodiment of the present disclosure.

For example, as illustrated in Fig. 3, at least one embodiment of the present disclosure further provides another display panel 02. As compared with the display panel 01 in Fig. 2, in the display panel 02, the thickness of the second isolation member 320 is larger in the direction perpendicular to the base substrate BS, and the rest of the structures are all the same, for which the relevant illustration about Fig. 2 in the above-described embodiment may be specifically referred to, and no details will be repeated here.

For example, as illustrated in Fig. 3, in the direction perpendicular to the base substrate BS, the thickness of the second isolation member 320 in the second partition structure 300 is basically equal to the maximum thickness of the portion of the organic layer 020 that is located in the first region A1. Thus, the second partition structure 300 has strong partition capability, for example, may partition all the film layers of the light-emitting functional layer 110 having a larger thickness, and partition the second electrode 130 together.

For example, as illustrated in Fig. 2 and Fig. 3, an orthogonal projection of the second isolation member 320 on the base substrate BS is completely within an orthogonal projection of the first isolation member 310 on the base substrate BS.

Fig. 4 is a schematic diagram of still another display panel provided by at least one embodiment of the present disclosure.

For example, as illustrated in Fig. 4, at least one embodiment of the present disclosure further provides still another display panel 03. As compared with the display panel 01 in Fig. 2, in the display panel 03, the second isolation member 320 in the second partition structure 300 is different, and the rest of the structures are all the same, for which the relevant description about Fig. 2 in the above-described embodiment may be specifically referred to, and no details will be repeated here.

For example, as illustrated in Fig. 4, the orthogonal projection of the first isolation member 310 of the second partition structure 300 on the base substrate BS falls into the orthogonal projection of the second isolation member 320 of the second partition structure 300 on the base substrate BS. For example, an orthogonal projection area of the second isolation member 320 of the second partition structure 300 on the base substrate BS is larger than an orthogonal projection area of the first isolation member 310 of the second partition structure 300 on the base substrate BS.

For example, as illustrated in Fig. 4, in the display panel 03, the second isolation member 320 includes a first sub-isolation portion 3201 and a second sub-isolation portion 3202; and the first sub-isolation portion 3201 is located on a side of the second sub-isolation portion 3202 that is away from the base substrate BS. An edge of the first isolation member 310 protrudes relative to an edge of the first sub-isolation portion 3201; and an edge of the second sub-isolation portion 3202 protrudes relative to the edge of the first isolation member 310.

Of course, in some embodiments, the edge of the first isolation member 310 protrudes relative to the edge of the first sub-isolation portion 3201; and the edge of the second sub-isolation portion 3202 may be flush with the edge of the first isolation member 310.

For example, as illustrated in Fig. 4, the first sub-isolation portion 3201 and the second sub-isolation portion 3202 are an integrated structure, and the two are made of a same material. For example, an orthogonal projection area of the first sub-isolation portion 3201 on the base substrate BS is smaller than an orthogonal projection area of the second sub-isolation portion 3202 on the base substrate BS; and an orthogonal projection of the first sub-isolation portion 3201 on the base substrate BS falls into an orthogonal projection of the second sub-isolation portion 3202 on the base substrate BS, which makes the second sub-isolation portion 3202 have a third protrusion portion 3211. For example, the second partition structure 300 may partition at least one film layer in the light-emitting functional layer 110 through the second protrusion portion 301, to reduce the risk of crosstalk. For example, an encapsulation layer is further provided on a side of the second electrode 130 that is away from the base substrate BS; by making the second sub-isolation portion 3202 have the third protrusion portion 3211, facilitating the encapsulation layer to lap on the second isolation member 320 through the third protrusion portion 3211, and facilitating "climbing" of the encapsulation layer, a risk of fracture of the encapsulation layer may be reduced to ensure continuity of the encapsulation layer. In addition, such arrangement may also make the second partition structure 300 have good stability, so that the second partition structure 300 is not prone to phenomena such as tilting and misalignment, etc.

For example, as illustrated in Fig. 4, in the direction perpendicular to the base substrate BS, a thickness of the first sub-isolation portion 3201 is smaller than a thickness of the second sub-isolation portion 3202. For example, the thickness of the first sub-isolation portion 3201 is 1/4 to 1/3, for example, 1/4, 7/24, or 1/3 of the thickness of the second sub-isolation portion 3202. For example, a size L1 of the first sub-isolation portion 3201 in the direction perpendicular to the base substrate BS may be 0.2 microns to 0.3 microns, for example, may be 0.2 microns, 0.25 microns, 0.28 microns, or 0.3 microns. For example, a size L2 of the second sub-isolation portion 3202 in the direction perpendicular to the base substrate BS may be 0.6 microns to 0.8 microns, for example, may be 0.6 microns, 0.65 microns, 0.7 microns, 0.75 microns, or 0.8 microns, which will not be limited in the embodiments of the present disclosure. For example, in the direction perpendicular to the base substrate BS, the maximum thickness of the second isolation member 320 is basically equal to the maximum thickness of the portion of the organic layer 020 that is located in the first display region A1, but it is not limited thereto.

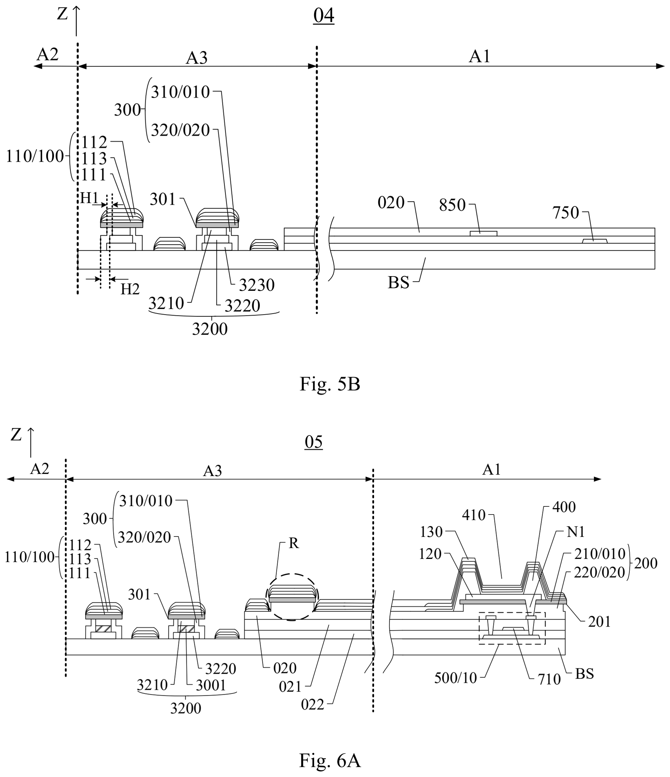

Fig. 5A is a schematic diagram of still another display panel provided by at least one embodiment of the present disclosure; and Fig. 5B is a schematic diagram of still another display panel provided by at least one embodiment of the present disclosure.

For example, as illustrated in Fig. 5A, at least one embodiment of the present disclosure further provides still another display panel 04. As compared with the display panel 01 in Fig. 2, in the display panel 04, the second isolation member 320 in the second partition structure 300 is different, and the rest of the structures are all the same; for which the relevant description about Fig. 2 in the above-described embodiment may be specifically referred to, and no details will be repeated here.

For example, as illustrated in Fig. 5A, the second partition structure 300 includes a first isolation member 310 and a second isolation member 320; and the first isolation member 310 is located on a side of the second isolation member 320 that is away from the base substrate BS. The second isolation member 320 includes at least one layer of metal structure 3200; and at least a portion of the organic layer 020 that is located in the third region A3 covers a surface of the at least one layer of metal structure 3200.

For example, as illustrated in Fig. 5A, the at least one layer of metal structure 3200 may include one or more layers of metal structure. For example, a layer of metal structure farthest away from the base substrate BS among the at least one layer of metal structure 3200 is in contact with the first isolation member 310. The at least one layer of metal structure 3200 may "elevate" the first isolation member 310, to facilitate the second protrusion portion 301 in the first isolation member 310 to partition at least one film layer in the light-emitting functional layer 110. For example, the at least a portion of the organic layer 020 that is located in the third region A3 covers the surface of the at least one layer of metal structure 3200, which may prevent the metal structure 3200 from being exposed, thereby preventing partitioned light-emitting functional layer 110 from being electrically connected with the metal structure 3200, so as to reduce the risk of crosstalk.

For example, as illustrated in Fig. 5A, the at least one layer of metal structure 3200 may include a first metal structure 3210 and a second metal structure 3220 sequentially stacked in the direction perpendicular to the base substrate BS; and the first metal structure 3210 is closer to the first isolation member 310 than the second metal structure 3220. The first metal structure 3210 is in contact with the first isolation member 310; and an orthogonal projection of the first metal structure 3210 on the base substrate BS falls into the orthogonal projection of the first isolation member 310 on the base substrate BS.

For example, as illustrated in Fig. 5A, an orthogonal projection area of the first metal structure 3210 on the first isolation member 310 is smaller than an orthogonal projection area of the second metal structure 3220 on the first isolation member 310; the edge of the first isolation member 310 protrudes relative to an edge of the first metal structure 3210; and an edge of the second metal structure 3220 protrudes relative to the edge of the first metal structure 3210. Such arrangement is favorable for making the edge of the first isolation member 310 protrude relative to the edge of the first metal structure 3210, so as to form a "bottom cut" structure, so that the second partition structure 300 has good partition function.

For example, as illustrated in Fig. 5A, the at least one layer of metal structure 3200 further includes a third metal structure 3230; the third metal structure 3230 is located on a side of the second metal structure 3220 that is close to the base substrate BS; and an orthogonal projection area of the third metal structure 3230 on the base substrate BS is larger than an orthogonal projection area of the second metal structure 3220 on the base substrate BS. Thus, the orthogonal projection area of the first metal structure 3210 on the base substrate BS, the orthogonal projection area of the second metal structure 3220 on the base substrate BS, and the orthogonal projection area of the third metal structure 3230 on the base substrate BS gradually increase. Therefore, the portion of the first isolation member 310 that protrudes relative to the first metal structure 3210 has a larger orthogonal projection area on the base substrate BS, which is favorable for forming a "bottom cut" structure. For example, in some embodiments, the at least one layer of metal structure 3200 may further include other metal structures, for example, the at least one layer of metal structure 3200 may be made to include 4 to 8 layers of metal structure, so that the second isolation member 320 has a larger thickness in the direction perpendicular to the base substrate BS, to facilitate the second partition structure 300 to partition the light-emitting functional layer 110 having a larger thickness; and the number of layers of metal structure in the second isolation member 320 will not be limited in the embodiments of the present disclosure.

For example, as illustrated in Fig. 5A, a thickness H1 of a portion of the organic layer 020 that covers a surface of the first metal structure 3210 is smaller than a thickness H2 of a portion of the organic layer 020 that covers a surface of the second metal structure 3220. For example, in a process of forming the first isolation member 310, the portion of the organic layer 020 that covers the surface of the first metal structure 3210 will be etched at a same time, there by reducing a thickness of the portion of the organic layer 020 and making the "bottom cut" structure of the second partition structure 300 more protruding.

For example, as illustrated in Fig. 5B, the display panel further includes a data line 850 and a gate line 750; and the data line 850 and the gate line 750 are respectively electrically connected with a pixel circuit (e.g., the pixel circuit 500 illustrated in Fig. 5A). The data line 850 is configured to supply a data signal to the pixel circuit. The gate line 750 is electrically connected with a gate electrode 710 in the pixel circuit; and the gate line 750 is configured to supply a scan signal, for example, a gate signal, to the pixel circuit. For example, the first metal structure 3210 may be arranged in a same layer as the data line 850, and the second metal structure 3220 may be arranged in a same layer as the gate line 750, so as to respectively simplify manufacturing processes of the first metal structure 3210 and the second metal structure 3220, and facilitate controlling manufacturing accuracy of the first metal structure 3210 and the second metal structure 3220.

Fig. 6A is a schematic diagram of still another display panel provided by at least one embodiment of the present disclosure.

For example, as illustrated in Fig. 6A, at least one embodiment of the present disclosure further provides still another display panel 05. As compared with the display panel 04 in Fig. 5A, in the display panel 05, the second isolation member 320 in the second partition structure 300 is different, and the rest of the structures are all the same, for which the relevant description about Fig. 5A in the above-described embodiment may be specifically referred to, and no details will be repeated here.

For example, as illustrated in Fig. 6A, the second isolation member 320 further includes an insulation structure 3001; the insulation structure 3001 is located between the first metal structure 3210 and the second metal structure 3220, so that the first metal structure 3210 and the second metal structure 3220 are insulated from each other; and the insulation structure 3001 includes an inorganic material. For example, the first metal structure 3210 and the second metal structure 3220 are spaced apart from each other through the insulation structure 3001, and a material of the insulation structure 3001 is different from a material of the organic layer 020, so as to reduce impact on the organic layer 020. For example, an orthogonal projection of the insulation structure 3001 on the base substrate BS is not smaller than the orthogonal projection of the first metal structure 3210 on the base substrate BS. For example, the orthogonal projection of the insulation structure 3001 on the base substrate BS may substantially coincide with the orthogonal projection of the first metal structure 3210 on the base substrate BS. For example, the insulation structure 3001 may be arranged in a same layer as the insulation structure located on the base substrate BS in the first region A1, so as to simplify a manufacturing process.

For example, as illustrated in Fig. 6A, in the direction perpendicular to the base substrate BS, the maximum thickness of the second isolation member 320 is 1/3 to 1, for example, may be 1/3 to 2/3 or 1/3 to 3/4, of the maximum thickness of the portion of the organic layer 020 that is located in the first region A1, which will not be limited in the embodiments of the present disclosure.

For example, as illustrated in Fig. 6A, the display panel 05 further includes a pixel defining pattern 400; the pixel defining pattern 400 is located in the first region A1 and is located on the base substrate BS; and the pixel defining pattern 400 includes a plurality of first openings 410 to define light-emitting regions of at least some sub-pixels 10. For example, one sub-pixel 10 corresponds to at least one first opening 410; at least a portion of a light-emitting element 100 of a sub-pixel 10 is located in a first opening 410 corresponding to the sub-pixel 10; and the first opening 410 is configured to expose a first electrode 120 of the sub-pixel 10. For example, the first opening 410 exposes a portion of the first electrode 120. For example, one sub-pixel 10 may correspond to one first opening 410.

For example, as illustrated in Fig. 6A, the pixel defining pattern 400 is located on a side of the first electrode 120 that is away from the base substrate BS; and the first partition structure 200 is located between the first electrode 120 and the base substrate BS. Upon the light-emitting functional layer 110 being formed in the first opening 410 of the pixel defining pattern 400, the first electrode 120 and the second electrode 130 located on both sides of the light-emitting functional layer 110 may drive the light-emitting functional layer 110 in the first opening 410 to emit light. For example, the above-described light-emitting region may refer to an effective light-emitting region of a sub-pixel; and a shape of the light-emitting region refers to a two-dimensional shape; for example, the shape of the light-emitting region may be the same as a shape of the first opening 410 of the pixel defining pattern 400.

For example, as illustrated in Fig. 6A, the first partition structure 200 is located in the first region A1 and is located between the light-emitting functional layer 110 and the base substrate BS; and the first partition structure 200 includes a portion surrounding a light-emitting region of each sub-pixel 10 among the at least some sub-pixels 10. For example, the first partition structure 200 is located between the first electrode 120 and the base substrate BS; and an orthogonal projection of the first opening 410 on the base substrate BS falls into the orthogonal projection of the first partition structure 200 on the base substrate BS. For example, an orthogonal projection of the first electrode 120 on the base substrate BS falls into the orthogonal projection of the first partition structure 200 on the base substrate BS.

For example, as illustrated in Fig. 6A, the display panel 01 further includes a pixel circuit 500. The pixel circuit 500 is located on a side of the first partition structure 200 that is close to the base substrate BS; and the pixel circuit 500 is electrically connected with the first electrode 120. For example, the pixel circuit 500 is configured to drive the light-emitting element 100 to emit light. For example, the pixel circuit 500 is configured to supply a driving current to drive the light-emitting element 100 to emit light. For example, the pixel circuit 500 may include a plurality of transistors and at least one capacitor (not illustrated); and the first electrode 120 may be electrically connected with the pixel circuit 500 through a connection via hole N1. For example, the pixel circuit may adopt design of 2T1C, 3T1C or 7T1C.

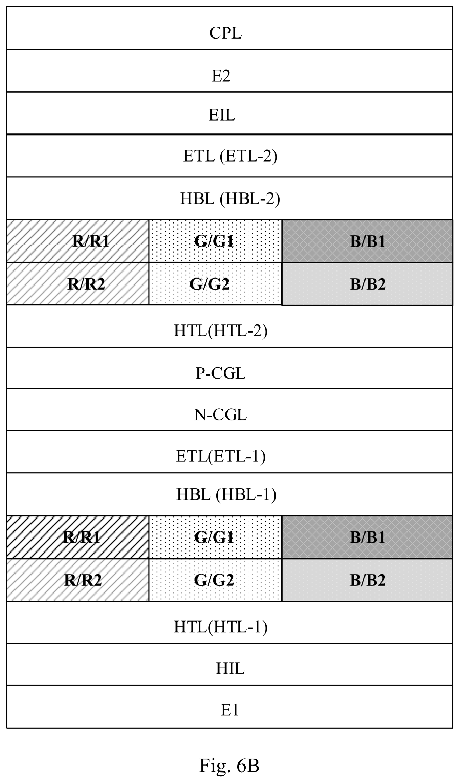

Fig. 6B is a schematic diagram of a light-emitting element having a Tandem structure.

For example, as illustrated in Fig. 6B, charge generation layers (CGLs) between different light-emitting elements having a Tandem structure are connected with each other. Fig. 6B illustrates a first electrode E1, a second electrode E2, a capping layer CPL, a hole transport layer HTL, a hole injection layer HIL, an electron transport layer ETL, an electron injection layer EIL, a hole blocking layer HBL, a P-type doped charge generation layer P-CGL, an N-type doped charge generation layer N-CGL, a light-emitting layer R, a light-emitting layer G, and a light-emitting layer B. As illustrated in Fig. 6B, the hole transport layer HTL includes a hole transport layer HTL-1 and a hole transport layer HTL-2. The electron transport layer ETL includes an electron transport layer ETL-1 and an electron transport layer ETL-2. The hole blocking layer HBL includes a hole blocking layer HBL-1 and a hole blocking layer HBL-2. For example, the hole transport layer HTL, the hole injection layer HIL, the electron transport layer ETL, the electron injection layer EIL, the hole blocking layer HBL, the P-type doped charge generation layer P-CGL, and the N-type doped charge generation layer N-CGL may serve as common layers of the light-emitting functional layer.

For example, as illustrated in Fig. 6B, the light-emitting layer R respectively includes a first light-emitting sub-layer R1 and a first auxiliary light-emitting layer R2; the light-emitting layer G respectively includes a second light-emitting sub-layer G1 and a second auxiliary light-emitting layer G2; and the light-emitting layer B respectively includes a third light-emitting sub-layer B1 and a third auxiliary light-emitting layer B2. For example, the first auxiliary light-emitting layer R2, the second auxiliary light-emitting layer G2, and the third auxiliary light-emitting layer B2 may adjust a micro-cavity thickness, adjust a carrier transport rate, and enable excitons to recombine and emit light in the light-emitting layer.

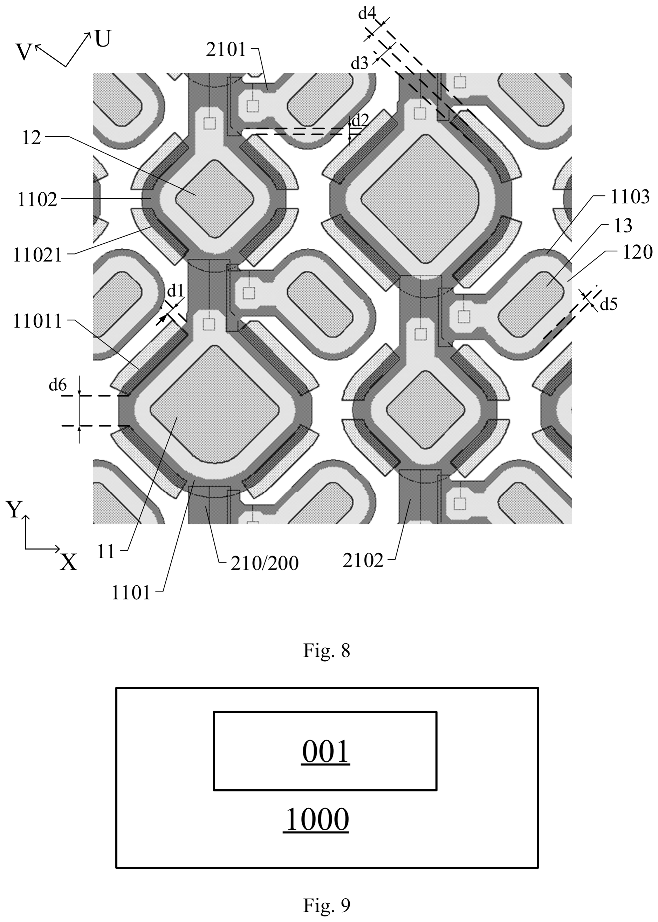

Fig. 7 is a structural diagram of the first region of the display panel illustrated in Fig. 1 in an example. Fig. 8 is a partially enlarged schematic diagram of an M region in Fig. 7.

For example, as illustrated in Fig. 6A and Fig. 7, the pixel defining pattern 400 further includes a second opening 420; a portion of at least one layer in the light-emitting functional layer 110 that is located in the first opening 410 is a continuous portion; at least a portion in the light-emitting functional layer 110 located in at least one second opening 420 is partitioned; and a portion in the first partition structure 200 that is exposed by the second opening 420 is configured to partition at least one film layer of the light-emitting functional layer 110.

For example, as illustrated in Fig. 6A and Fig. 7, the portion in the first partition structure 200 that is exposed by the second opening 420 includes a partition portion 415; the partition portion 415 is provided between at least two adjacent sub-pixels 10; and at least one film layer in the light-emitting functional layer 110 is disconnected at an edge of the partition portion 415. By arranging a partition portion 415 for partitioning at least one film layer in the light-emitting functional layer 110 between adjacent sub-pixels 10, it is favorable for reducing a probability of crosstalk between the adjacent sub-pixels 10. For example, the above-described partition portion 415 refers to a structure in the first partition structure 200 that is exposed by the second opening 420.

In any embodiment of the present disclosure, "adjacent sub-pixels" refer to two sub-pixels without any other sub-pixel arranged between them. The adjacent sub-pixels may be two sub-pixels of a same color or two sub-pixels of different colors.

For example, as illustrated in Fig. 6A and Fig. 7, at least a portion of the second electrode 120 is disconnected at the edge of the partition portion 415.

For example, as illustrated in Fig. 7, the display panel 01 includes a first sub-pixel 11, a second sub-pixel 12 and a third sub-pixel 13. For example, the first sub-pixel 11, the second sub-pixel 12 and the third sub-pixel 13 are configured to emit light of different colors, but it is not limited thereto. For example, any two of the first sub-pixel 11, the second sub-pixel 12 and the third sub-pixel 13 may be configured to emit light of a same color. For example, an area of a light-emitting region of one first sub-pixel 11 is larger than an area of a light-emitting region of one second sub-pixel 12; and an area of a light-emitting region of one first sub-pixel 11 is larger than an area of a light-emitting region of one third sub-pixel 13. For example, an area of a light-emitting region of one second sub-pixel 12 is larger than an area of a light-emitting region of one third sub-pixel 13.

In some examples, as illustrated in Fig. 7, the first sub-pixel 11 is a blue sub-pixel; one of the second sub-pixel 12 and the third sub-pixel 13 is a red sub-pixel, and the other of the second sub-pixel 12 and the third sub-pixel 13 is a green sub-pixel. Fig. 7 schematically illustrates that the second sub-pixel 12 is a red sub-pixel, and the third sub-pixel 13 is a green sub-pixel, but it is not limited thereto. For example, the second sub-pixel 12 may be a green sub-pixel; and the third sub-pixel 13 may be a red sub-pixel.

For example, as illustrated in Fig. 6A and Fig. 7, in the direction perpendicular to the base substrate BS, the first partition structure 200 includes a portion that overlaps with the pixel defining pattern 400, a portion that overlaps with the first opening 410, and a portion that overlaps with the second opening 420. The portion in the first partition structure 200 that is exposed by the second opening 420 is configured to partition at least one film layer of the light-emitting functional layer 110. For example, the display panel 01 includes a first partition portion 1101, a second partition portion 1102 and a third partition portion 1103. For example, the first partition portion 1101 includes a portion that overlaps with the light-emitting region of the first sub-pixel 11 and a portion that surrounds the light-emitting region of the first sub-pixel 11; the second partition portion 1102 includes a portion that overlaps with the light-emitting region of the second sub-pixel 12 and a portion that surrounds the light-emitting region of the second sub-pixel 12; and the third partition portion 1103 includes a portion that overlaps with the light-emitting region of the third sub-pixel 13 and a portion that surrounds the light-emitting region of the third sub-pixel 13.

For example, as illustrated in Fig. 7, a portion of the first partition portion 1101 that is exposed by the second opening 420 is a first defining partition portion 11011; and a portion of the second partition portion 1102 that is exposed by the second opening 420 is a second defining partition portion 11021. For example, the light-emitting functional layer 110 and the second electrode 130 of the first sub-pixel 11 are disconnected at an edge of the first defining partition portion 11011. The light-emitting functional layer 110 and the second electrode 130 of the second sub-pixel 12 are disconnected at an edge of the second defining partition portion 11021.

For example, as illustrated in Fig. 7, only one first defining partition portion 11011 or one second defining partition portion 11021 is arranged between two adjacent sub-pixels arranged in a U direction; and only one first defining partition portion 11011 or one second defining partition portion 11021 is arranged between two adjacent sub-pixels arranged in a V direction, which thus is favorable for balancing crosstalk and power consumption between adjacent sub-pixels. For example, both the U direction and the V direction are parallel to the base substrate, and the U direction is perpendicular to the V direction.

For example, as illustrated in Fig. 7, a portion of the first partition portion 1101 corresponding to the first sub-pixel 11 that is exposed by the second opening 420 is a structure spaced apart; and a portion of the second partition portion 1102 corresponding to the second sub-pixel 12 that is exposed by the second opening 420 is a structure spaced apart. Orthogonal projections of the first defining partition portion 11011 and the second defining partition portion 11021 on the base substrate both have a shape of a non-closed ring. The third partition portion 1103 corresponding to the third sub-pixel 13 is not exposed by the second opening 420.

For example, as illustrated in Fig. 7, the first sub-pixel 11 includes a first corner portion 011 formed by connecting two adjacent edges of the light-emitting region thereof, a second corner portion 012 formed by connecting two adjacent edges of the light-emitting region thereof, a third corner portion 013 formed by connecting two adjacent edges of the light-emitting region thereof, and a fourth corner portion 014 formed by connecting two adjacent edges of the light-emitting region thereof. The portion of the first partition portion 1101 corresponding to the first sub-pixel 11 that is exposed by the second opening 420 only surrounds a portion of the two adjacent edges of the light-emitting region thereof except the first corner portion 011, a portion of the two adjacent edges of the light-emitting region thereof except the second corner portion 012, a portion of the two adjacent edges of the light-emitting region thereof except the third corner portion 013, and a portion of the two adjacent edges of the light-emitting region thereof except the fourth corner portion 014, which, thus, is favorable for improving continuity of the second electrode 130 (as illustrated in Fig. 6A) and reducing power consumption of the display panel.

For example, as illustrated in Fig. 7, the second sub-pixel 12 includes a fifth corner portion 015 formed by connecting two adjacent edges of the light-emitting region thereof, a sixth corner portion 016 formed by connecting two adjacent edges of the light-emitting region thereof, a seventh corner portion 017 formed by connecting two adjacent edges of the light-emitting region thereof, and an eighth corner portion 018 formed by connecting two adjacent edges of the light-emitting region thereof. The portion of the second partition portion 1102 corresponding to the second sub-pixel 12 that is exposed by the second opening 420 only surrounds a portion of the two adjacent edges of the light-emitting region thereof except the fifth corner portion 015, a portion of the two adjacent edges of the light-emitting region thereof except the sixth corner portion 016, a portion of the two adjacent edges of the light-emitting region thereof except the seventh corner portion 017, and a portion of the two adjacent edges of the light-emitting region thereof except the eighth corner portion 018, which, thus, is favorable for improving continuity of the second electrode 130 (as illustrated in Fig. 6A) and reducing power consumption of the display panel.

For example, as illustrated in Fig. 8, the display panel includes a plurality of first connection portions 2101 extending in a direction X, and a plurality of second connection portions 2102 extending in a direction Y. The first connection portion 2101 and the second connection portion 2102 are both integrated with the first isolation portion 210; the first partition portion 1101 is connected with the second partition portion 1102 through the second connection portion 2102; and the third isolation portion 1103 is connected with the second connection portion 2102 through the first connection portion 2101. The second connection portion 2102 extends in the direction Y and substantially has a "strip" shape to reduce a risk of peeling and facilitate outgassing of the organic layer 020 located on a side of the first isolation portion 210 that is close to the base substrate BS. For example, both the direction X and the direction Y are parallel to the base substrate BS; and the direction X is perpendicular to the direction Y. For example, the direction X intersects with the direction U; and the direction Y intersects with the direction V. For example, an included angle between the direction X and the direction U is 45 °; and an included angle between the direction Y and the direction V is 45 °.

For example, as illustrated in Fig. 8, the minimum distance between the orthogonal projection of the second opening 420 corresponding to the first sub-pixel 11 or the second sub-pixel 12 on the base substrate and an orthogonal projection of the second connection portion 2102 on the base substrate is d1; and d1 is greater than 2 microns, for example, may be 3 microns or 4 microns, so that in a case of complying with a process deviation, the portion of the first partition portion 1101 corresponding to the first sub-pixel 11 that is exposed by the second opening 420 may effectively partition at least one film layer in the light-emitting functional layer, or the portion of the second partition portion 1102 corresponding to the second sub-pixel 12 that is exposed by the second opening 420 may effectively partition at least one film layer in the light-emitting functional layer.

For example, as illustrated in Fig. 8, the minimum distance between the orthogonal projection of the second opening 420 corresponding to the first sub-pixel 11 or the second sub-pixel 12 on the base substrate and the orthogonal projection of the second connection portion 2102 on the base substrate is d2; and d2 is greater than 2 microns, for example, may be 3 microns or 4 microns, so that in a case of complying with a process deviation, the portion of the first partition portion 1101 corresponding to the first sub-pixel 11 that is exposed by the second opening 420 may effectively partition at least one film layer in the light-emitting functional layer, or the portion of the second partition portion 1102 corresponding to the second sub-pixel 12 that is exposed by the second opening 420 may effectively partition at least one film layer in the light-emitting functional layer.

For example, as illustrated in Fig. 8, the portion of the first partition portion 1101 corresponding to the first sub-pixel 11 that is exposed by the second opening 420 has a shape of a non-closed first partition ring; the portion of the second partition portion 1102 corresponding to the second sub-pixel 12 that is exposed by the second opening 420 has a shape of a non-closed second partition ring; an average ring width of the first partition ring and an average ring width of the second partition ring are both d3; and d3 is greater than 3 microns, for example, may be 4 microns or 5 microns, so that orthogonal projection areas of the portions of the first partition portion 1101 and the second partition portion 1102 that are exposed by the second opening 420 on the base substrate are large enough, to meet the requirement of partitioning at least one film layer in the light-emitting functional layer.

For example, as illustrated in Fig. 8, the orthogonal projection of the second opening 420 corresponding to the first sub-pixel 11 on the base substrate has a shape of a non-closed ring; a difference between an average ring width of this non-closed ring and the average ring width d3 of the above-described first partition ring is d4; and d4 is greater than 3 microns, for example, may be 4 microns or 5 microns. For example, the orthogonal projection of the second opening 420 corresponding to the second sub-pixel 12 on the base substrate has a shape of a non-closed ring; and a difference between an average ring width of this non-closed ring and the average ring width d3 of the above-described second partition ring is also d4. For example, the orthogonal projection of the second opening 420 on the base substrate has a shape of a non-closed ring; and a ring width of the ring is d3+d4, and is greater than 10 microns, for example, may be 11 microns, 12 microns, or 13 microns.

Such arrangement may allow the second opening 420 to have an opening area large enough, which facilitates the portion of the first partition portion 1101 that is exposed by the second opening 420 to partition at least one film layer in the light-emitting functional layer, and facilitates the portion of the second partition portion 1102 that is exposed by the second opening 420 to partition at least one film layer in the light-emitting functional layer.

For example, as illustrated in Fig. 8, the third partition portion 1103 corresponding to the third sub-pixel 13 is not exposed by the second opening 420; an orthogonal projection of a portion of the third partition portion 1103 that exceeds the first electrode 120 of the third sub-pixel 13 on the base substrate substantially has a shape of a ring; an average ring width of the ring is d5; and d5 is not greater than 3 microns, for example, may be 2 microns, 1 microns, or 0.5 microns, which is favorable for improving continuity of the second electrode 130 (as illustrated in Fig. 6A).

For example, as illustrated in Fig. 7 and Fig. 8, the portion of the first partition portion 1101 corresponding to the first sub-pixel 11 that is exposed by the second opening 420 includes a plurality of sub-portions spaced apart, for example, a first sub-portion 1001, a second sub-portion 1002, a third sub-portion 1003, and a fourth sub-portion 1004; the minimum distance between second openings 420 respectively corresponding to adjacent sub-portions (e.g., the first sub-portion 1001 and the second sub-portion 1002) is d6; and d6 is not less than 20 microns, for example, may be 22 microns, 24 microns, or 25 microns, etc. For example, the portion of the second partition portion 1102 corresponding to the second sub-pixel 12 that is exposed by the second opening 420 also includes a plurality of sub-portions spaced apart; the minimum distance between second openings 420 respectively corresponding to adjacent sub-portions is also d6. Such arrangement is favorable for ensuring continuity of the second electrode 130 (as illustrated in Fig. 6A), so that second electrodes 130 of adjacent sub-pixels 10 may well lap on each other, and is favorable for reducing power consumption.

For example, as illustrated in Fig. 6A and Fig. 7, a spacer 800 may further be provided on a side of the pixel defining pattern 400 that is away from the base substrate BS; the spacer 800 may serve as a support layer and be configured to support a evaporation mask, for example, a fine metal mask (FMM), for manufacturing the light-emitting functional layer 110. For example, an orthogonal projection of the spacer 800 on the base substrate BS falls into the orthogonal projection of the second connection portion 2102 on the base substrate BS; and the spacer 800 is spaced apart from the connection via hole N1. For example, the minimum distance between the spacer 800 and the connection via hole N1 is greater than 3 microns, for example, may be 3.5 microns, 4 microns, or 5 microns, to reduce impact on the pixel circuit 500.

Fig. 9 is a schematic block diagram of a display apparatus provided by at least one embodiment of the present disclosure.

As illustrated in Fig. 9, the display apparatus 1000 includes a display panel 001. The display panel 001 may be the display panel according to any one of the above-described embodiments.

For example, the display apparatus 1000 may be an organic light-emitting diode display apparatus.

For example, the display apparatus 1000 may further include a cover plate located on a light emergent side of the display substrate 001.

For example, the display apparatus 1000 may be a television, a digital camera, a mobile phone, a watch, a tablet personal computer, a laptop, a navigator, and any other product or component having a display function, and this embodiment is not limited thereto.

For example, the display apparatus 1000 may be a medium to large-sized intelligent handheld display apparatus (a notebook (NB)) or a touch display apparatus (a tablet personal computer (TPC)), and also has broad application potential in the field of foldable products.

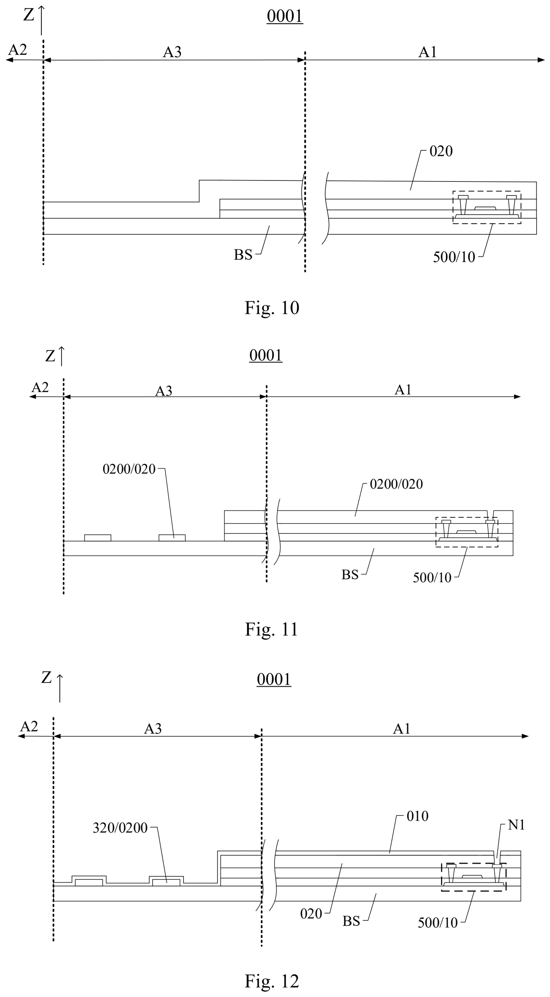

Fig. 10 to Fig. 14 are flow charts of a manufacturing method of a display panel provided by an embodiment of the present disclosure.

At least one embodiment of the present disclosure further provides a manufacturing method of a display panel. For example, the manufacturing method is applicable to the display panel according to any one of the above-described embodiments.

As illustrated in Fig. 10, the display panel 0001 includes a first region A1, a second region A2, and a third region A3 located between the first region A1 and the second region A2; the first region A1 is configured to display; the second region A2 is configured to transmit light; and the first region A1 is located on at least one side of the second region A2. For example, the first region A1 is a display region, and is configured to display. The second region A2 is a hollow region, and is configured to transmit light. For example, hardware such as a photosensitive sensor may be arranged in the second region A2.

As illustrated in Fig. 10 and Fig. 11, the manufacturing method of the display panel 0001 includes:
Forming an organic material layer 020 on a base substrate BS, and patterning the organic material layer 020, to form an organic layer pattern 0200 in the third region A3.

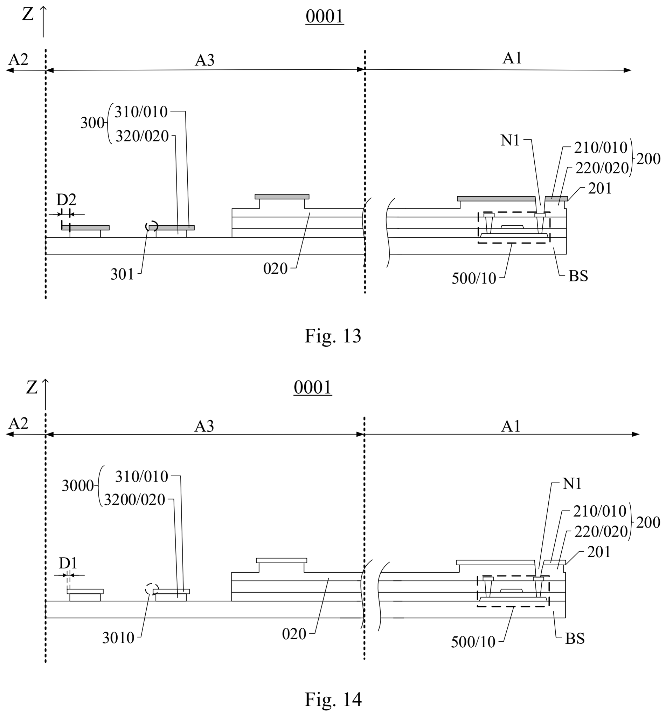

Then, as illustrated in Fig. 12 and Fig. 13, forming an inorganic material layer 010 on the organic layer pattern 0200, and patterning the inorganic material layer 010, to form a first partition structure 200 in the first region A1, and form a second partition structure 300 in the third region A3. For example, as illustrated in Fig. 14, after patterning the inorganic material layer 010, a first isolation portion 210 is formed in the first region A1, and a first isolation member 310 is formed in the third region A3; so that the first isolation portion 210 is formed after patterning at least a portion of the inorganic material layer 010 that is located in the first region A1, and the first isolation member 310 is formed after patterning at least a portion of the inorganic material layer 010 that is located in the third region A3.

As illustrated in Fig. 13, both the first partition structure 200 and the second partition structure 300 are configured to partition at least one layer of the light-emitting functional layer 110. The first partition structure 200 includes the first isolation portion 210 and a second isolation portion 220 stacked; the first isolation portion 210 is located on a side of the second isolation portion 220 that is away from the base substrate BS; the first isolation portion 210 includes a first protrusion portion 201; and the first protrusion portion 201 protrudes relative to an edge of the second isolation portion 220. The second partition structure 300 includes the first isolation member 310 and a second isolation member 320 stacked; the first isolation member 310 is located on a side of the second isolation member 320 that is away from the base substrate BS; the first isolation member 310 includes a second protrusion portion 301; and the second protrusion portion 301 protrudes relative to at least a portion of an edge of the second isolation member 320. For example, the second protrusion portion 301 protrudes relative to a portion of an edge of the second isolation member 320 that is close to and in contact with the first isolation member 310.

The manufacturing method of the display panel proposed by the embodiment of the present disclosure is simple and easy to implement, so that the first isolation portion 210 and the first isolation member 310 may be patterned with a same mask, which simplifies a manufacturing process and makes it easy to control process deviations; and meanwhile, the structures of the first partition structure 200 and the second partition structure 300 are simple, so that the first partition structure 200 located in the first display region A1 and the second partition structure 300 located in the third region A3 have good uniformity in structure.

For example, as illustrated in Fig. 12 to Fig. 14, forming the inorganic material layer 010 on the organic layer pattern 0200, and patterning the inorganic material layer 010, to form the first partition structure 200 in the first region A1, and form the second partition structure 300 in the third region A3, includes:

Firstly, as illustrated in Fig. 12 and Fig. 14, patterning the inorganic material layer 010, to form the first partition structure 200 in the first region A1, and form an initial partition structure 3000 in the third region A3; the initial partition structure 3000 including the first isolation member 310 and an initial isolation member 3200; the first isolation member 310 and the initial isolation member 3200 being stacked; and an edge of the first isolation member 310 protruding relative to at least a portion of an edge of the initial isolation member 3200. For example, the portion of the first isolation member 310 that protrudes relative to at least a portion of the edge of the initial isolation member 3200 is an initial protrusion portion 3010; a projection of the initial protrusion portion 3010 on the base substrate BS has a shape of a ring; and an average ring width of the ring is D1.

Then, as illustrated in Fig. 13 and Fig. 14, further etching the initial isolation member 3200 in the third region A3 in Fig. 14, to form the second partition structure 300 in Fig. 13. For example, a layer of mask may be additionally arranged in the third region A3 to etch the initial isolation member 3200, so that at least a portion of the initial isolation member 3200 that is located directly below the first isolation member 310 is etched. For example, a portion of the first isolation member 310 that protrudes relative to at least a portion of an edge of the second isolation member 320 is a second protrusion portion 301; an orthogonal projection of the second protrusion portion 301 on the base substrate BS has a shape of a ring; and an average ring width of the ring is D2. As illustrated in Fig. 13 and Fig. 14, D2 is larger than D1. Thus, by further etching the initial isolation member 3200 in the third region A3, the second partition structure 300 may have a clear "bottom cut" structure, to enhance partition capability. For example, in some embodiments, in the first region A1, the first partition structure 200 only partitions some film layers in the light-emitting functional layer, without partitioning the second electrode. In the third region A3, the second partition structure 300 partitions all the film layers in the light-emitting functional layer, and also partition the second electrode together, so that the second partition structure 300 have stronger partition capability.

For example, as illustrated in Fig. 10, the manufacturing method of the display panel provided by the embodiment of the present disclosure may include: preparing the base substrate BS on a glass carrier plate. For example, the base substrate BS may be a flexible base substrate. For example, the forming the base substrate BS may include sequentially forming a first flexible material layer, a first inorganic material layer, a semiconductor layer, a second flexible material layer, and a second inorganic material layer stacked on the glass carrier plate. The first flexible material layer and the second flexible material layer are made of polyimide (PI), polyethylene terephthalate (PET), or surface-treated polymer soft films. For example, the first inorganic material layer and the second inorganic material layer are made of silicon nitride (SiNx) or silicon oxide (SiOx), etc., to improve water oxygen resistance ability of the base substrate; and the first inorganic material layer and the second inorganic material layer are also referred to as barrier layers.

For example, as illustrated in Fig. 10, the manufacturing method of the display panel provided by the embodiment of the present disclosure may include: forming a driving structure layer of a pixel circuit on the base substrate BS. The driving structure layer includes a plurality of pixel circuits 500; each pixel circuit includes a plurality of transistors and at least one storage capacitor; for example, the pixel circuit 500 may adopt design of 2T1C, 3TIC or 7T1C. For example, in some embodiments, forming the driving structure layer may include: sequentially depositing a first insulation thin film and an active layer thin film on the base substrate BS, and patterning the active layer thin film by using a patterning process, to form a first insulation layer covering the entire base substrate BS, and an active layer pattern provided on the first insulation layer; the active layer pattern at least including an active layer. For example, a second insulation thin film and a first metal thin film are sequentially deposited, and the first metal thin film is patterned by using a patterning process, to form a second insulation layer covering the active layer pattern, and a first gate metal layer pattern provided on the second insulation layer; and the first gate metal layer pattern at least includes a gate electrode and a first capacitor electrode. For example, a third insulation thin film and a second metal thin film are sequentially deposited, and the second metal thin film is patterned by using a patterning process, to form a third insulation layer covering the first gate metal layer, and a second gate metal layer pattern provided on the third insulation layer; the second gate metal layer pattern at least includes a second capacitor electrode; and a position of the second capacitor electrode corresponds to a position of the first capacitor electrode. Subsequently, a fourth insulation thin film is deposited; the fourth insulation thin film is patterned by using a patterning process, to form a fourth insulation layer covering the second gate metal layer; at least two via holes are opened in the fourth insulation layer; and the fourth insulation layer, the third insulation layer and the second insulation layer inside the two via holes are etched away, to expose a surface of the active layer in the active layer pattern. Subsequently, a third metal thin film is deposited, and the third metal thin film is patterned by using a patterning process, to form a source-drain metal layer pattern in the fourth insulation layer; and the source-drain metal layer pattern at least includes a source electrode and a drain electrode located in a display region. The source electrode and the drain electrode may be respectively connected with the active layer in the active layer pattern through the via holes.

For example, the first insulation layer, the second insulation layer, the third insulation layer and the fourth insulation layer as described above may be made of any one or more of silicon oxide (SiOx), silicon nitride (SiNx), and silicon oxynitride (SiON), which may be a single-layer structure, a multi-layer structure, or a composite-layer structure. For example, the first insulation layer may be a buffer layer used for improving water oxygen resistance ability of the base substrate BS. For example, the second insulation layer and the third insulation layer may be gate insulator (GI) layers. For example, the fourth insulation layer may be an interlayer dielectric (ILD) layer. For example, the first metal thin film, the second metal thin film and the third metal thin film are made of metal materials, for example, any one or more of silver (Ag), copper (Cu), aluminum (Al), titanium (Ti), and molybdenum (Mo), or alloy materials of the above-described metals, for example, an aluminum neodymium alloy (AlNd) or a molybdenum niobium alloy (MoNb), which may be a single-layer structure or a multi-layer composite structure, for example, Ti/Al/Ti, etc. For example, the active layer thin film is made of one or more materials such as amorphous indium gallium zinc oxide (a-IGZO), zinc nitride oxide (ZnON), indium zinc tin oxide (IZTO), amorphous silicon (a-Si), polycrystalline silicon (p-Si), hexathiophene, polythiophene, etc., that is, the present disclosure is applicable to transistors manufactured based on oxide technologies, silicon technologies, and organic technologies.

For example, as illustrated in Fig. 2, after the forming the first partition structure 200 and the second partition structure 300, the manufacturing method of the display panel provided by the embodiment of the present disclosure further includes: patterning on the first partition structure 200 to form the first electrode 120. For example, the first electrode 120 may be made of any one or more of metal materials, for example, magnesium (Mg), silver (Ag), copper (Cu), aluminum (Al), titanium (Ti) and molybdenum (Mo), or alloy materials of the above-described metals, for example, an aluminum neodymium alloy (AlNd) or a molybdenum niobium alloy (MoNb), which may be a single-layer structure, or a multi-layer composite structure, for example, Ti/Al/Ti, or a stack structure formed by metal and transparent conductive materials, for example, reflective materials such as ITO/Ag/ITO, Mo/AlNd/ITO, etc. For example, the first electrode 120 is electrically connected with the pixel circuit 500 through the via hole N1.

For example, as illustrated in Fig. 2, after forming the first electrode 120, a pixel defining pattern 400 may be formed. For example, a pixel defining thin film is coated on the base substrate BS on which the foregoing pattern is formed; and the pixel defining pattern 400 is formed by using masking, exposure, and development processes. For example, the pixel defining pattern 400 in the first region A1 includes a first opening 410 and a second opening 420 (as illustrated in Fig. 7); pixel defining films within the first opening 410 and the second opening 420 are developed away; the first opening 410 exposes at least a portion of a surface of the first electrode 120 of each of a plurality of sub-pixels 10; and the second opening 420 exposes the first partition structure 200.

For example, as illustrated in Fig. 2 and Fig. 7, after forming the pixel defining pattern 400, a spacer 800 may be formed on the pixel defining pattern 400. For example, an organic material thin film is coated on the base substrate BS on which the foregoing pattern is formed; and the spacer is formed by using masking, exposure, and development processes. The spacer may serve as a support layer, and is configured to support a fine metal mask (FMM) in an evaporation process.

For example, as illustrated in Fig. 2 and Fig. 7, after forming the spacer 800, the light-emitting functional layer 110 and the second electrode 130 are sequentially formed. For example, the second electrode 130 may be a transparent cathode. The light-emitting functional layer 110 may emit light from a side away from the base substrate BS through the transparent cathode, to implement top emission. For example, the second electrode 130 may be made of any one or more of magnesium (Mg), silver (Ag), aluminum (Al), or alloys made of any one or more of the above-described metals, or transparent conductive materials, for example, indium tin oxide (ITO), or a multi-layer composite structure of metals and transparent conductive materials.

For example, as illustrated in Fig. 2, the forming the light-emitting functional layer 110 may include: sequentially evaporating with an open mask to form a hole injection layer and a hole transport layer; sequentially evaporating with a fine metal mask (FMM) to form a first light-emitting layer 111 that emits light of different colors, for example, a blue light-emitting layer, a green light-emitting layer, or a red light-emitting layer; sequentially evaporating with an open mask to form an electron transport layer, a charge generation layer 113, and a hole transport layer; sequentially evaporating with a fine metal mask (FMM) to form a second light-emitting layer 112 that emits light of different colors, for example, a blue light-emitting layer, a green light-emitting layer, or a red light-emitting layer; and sequentially evaporating with an open mask to form an electron transport layer, a second electrode 130 and a capping layer. For example, the hole injection layer, the hole transport layer, the electron transport layer, the charge generation layer, the second electrode 130 and the capping layer are all common layers of the plurality of sub-pixels.

For example, as illustrated in Fig. 2 and Fig. 7, in the first region A1, the formed light-emitting functional layer 110 is disconnected at an edge of the first partition structure 200, thereby reducing a risk of crosstalk between adjacent sub-pixels 10. In the third region A3, the formed light-emitting functional layer 110 will be disconnected at an edge of the second partition structure 300, thereby further reducing a risk of crosstalk between sub-pixels 10 located in the vicinity of the edge of the first region A1.

For example, after forming the second electrode, the manufacturing method of the display panel further includes: forming an encapsulation layer; in which the encapsulation layer may include a first encapsulation layer, a second encapsulation layer, and a third encapsulation layer stacked. The first encapsulation layer is made of an inorganic material and covers the second electrode in the display region. The second encapsulation layer is made of an organic material. The third encapsulation layer is made of an inorganic material, and covers the first encapsulation layer and the second encapsulation layer. However, this will not be limited in this embodiment. For example, the encapsulation layer may also adopt a five-layer structure of inorganic/organic/inorganic/organic/inorganic.

The following statements should be noted:
(1) The accompanying drawings related to the embodiment(s) of the present disclosure involve only the structure(s) in connection with the embodiment(s) of the present disclosure, and other structure(s) can be referred to common design(s).
(2) In case of no conflict, features in one embodiment or in different embodiments of the present disclosure can be combined.

The foregoing is merely exemplary embodiments of the disclosure, but is not used to limit the protection scope of the disclosure. The protection scope of the disclosure shall be defined by the attached claims.

## Claims

1. A display panel, comprising:
a first region, configured to display;
a second region, configured to transmit light, the first region being located on at least one side of the second region;
a third region, located between the first region and the second region;
a plurality of sub-pixels, located in the first region, each sub-pixel of at least some sub-pixels comprising a light-emitting functional layer, and the light-emitting functional layer comprising a plurality of film layers;
a base substrate, and an inorganic layer located on the base substrate;
a first partition structure, located on the base substrate and located between adjacent sub-pixels in the first region, the first partition structure comprising a first isolation portion and a second isolation portion stacked, the first isolation portion being located on a side of the second isolation portion that is away from the base substrate, and the first isolation portion comprising a first protrusion portion that protrudes relative to an edge of the second isolation portion;
a second partition structure, located on the base substrate and located in the third region, the second partition structure comprising a first isolation member and a second isolation member stacked, the first isolation member being located on a side of the second isolation member that is away from the base substrate, and the first isolation member comprising a second protrusion portion that protrudes relative to at least a portion of an edge of the second isolation member;
wherein the first partition structure and the second partition structure are both configured to partition at least one layer of the light-emitting functional layer, at least a portion of the inorganic layer that is located in the first region serves as the first isolation portion, and at least a portion of the inorganic layer that is located in the third region serves as the first isolation member.

2. The display panel according to claim 1, further comprising an organic layer located on the base substrate, the inorganic layer being located on a side of the organic layer that is away from the base substrate,
wherein at least a portion of the organic layer that is located in the first region serves as the second isolation portion, and at least a portion of the organic layer that is located in the third region serves as at least a portion of the second isolation member.

3. The display panel according to claim 1 or 2, wherein an orthogonal projection of the first protrusion portion of the first isolation portion on the base substrate has a shape of a first ring, an orthogonal projection of the second protrusion portion of the first isolation member on the base substrate has a shape of a second ring, and an average ring width of the first ring is smaller than an average ring width of the second ring.

4. The display panel according to claim 3, wherein the average ring width of the second ring is 1.2 to 3 times the average ring width of the first ring.

5. The display panel according to any one of claims 1 to 4, wherein in a direction perpendicular to the base substrate, a thickness of the first isolation portion is basically equal to a thickness of the first isolation member.

6. The display panel according to claim 2, wherein in a direction perpendicular to the base substrate, a maximum thickness of a portion of the organic layer that is located in the first region is larger than or equal to a maximum thickness of a portion of the organic layer that is located in the third region.

7. The display panel according to claim 6, wherein an orthogonal projection of the first isolation member of the second partition structure on the base substrate falls into an orthogonal projection of the second isolation member of the second partition structure on the base substrate.

8. The display panel according to claim 6 or 7, wherein the second isolation member comprises a first sub-isolation portion and a second sub-isolation portion, the first sub-isolation portion is located on a side of the second sub-isolation portion that is away from the base substrate,
an edge of the first isolation member protrudes relative to an edge of the first sub-isolation portion, and an edge of the second sub-isolation portion protrudes relative to the edge of the first isolation member, or is flush with the edge of the first isolation member.

9. The display panel according to claim 2, wherein the second isolation member comprises at least one layer of metal structure, and the at least a portion of the organic layer that is located in the third region covers a surface of the at least one layer of metal structure.

10. The display panel according to claim 9, wherein the at least one layer of metal structure comprises a first metal structure and a second metal structure sequentially stacked in a direction perpendicular to the base substrate, the first metal structure is closer to the first isolation member than the second metal structure, and an edge of the second metal structure protrudes relative to an edge of the first metal structure.

11. The display panel according to claim 10, wherein the first metal structure is in contact with the first isolation member, and an orthogonal projection of the first metal structure on the base substrate falls into an orthogonal projection of the first isolation member on the base substrate.

12. The display panel according to claim 11, wherein a thickness of a portion of the organic layer that covers a surface of the first metal structure is smaller than a thickness of a portion of the organic layer that covers a surface of the second metal structure.

13. The display panel according to claim 10, wherein the second isolation member further comprises an insulation structure, the insulation structure is located between the first metal structure and the second metal structure, so that the first metal structure and the second metal structure are insulated from each other, and the insulation structure comprises an inorganic material.

14. The display panel according to any one of claims 9 to 13, wherein in a direction perpendicular to the base substrate, a maximum thickness of the second isolation member is 1/3 to 1 of a maximum thickness of the portion of the organic layer that is located in the first region.

15. The display panel according to any one of claims 10 to 14, further comprising:
a pixel defining pattern, located in the first region and located on the base substrate, the pixel defining pattern comprising a plurality of first openings to define light-emitting regions of the at least some sub-pixels;
wherein the first partition structure is located between the light-emitting functional layer and the base substrate, and the first partition structure comprises a portion surrounding a light-emitting region of each sub-pixel among the at least some sub-pixels;
the pixel defining pattern further comprises a second opening, a portion of at least one layer in the light-emitting functional layer that is located in the first opening is a continuous portion, at least a portion of the at least one layer in the light-emitting functional layer that is located in at least one second opening is partitioned, and a portion of the first partition structure that is exposed by the second opening is configured to partition the at least one layer of the light-emitting functional layer;
each sub-pixel among the at least some sub-pixels further comprises: a first electrode and a second electrode located on both sides of the light-emitting functional layer in the direction perpendicular to the base substrate, the first electrode is located between the light-emitting functional layer and the base substrate, the pixel defining pattern is located on a side of the first electrode that is away from the base substrate, and the first partition structure is located between the first electrode and the base substrate;
the display panel further comprises a pixel circuit, the pixel circuit is located on a side of the first partition structure that is close to the base substrate, and the pixel circuit is electrically connected with the first electrode.

16. The display panel according to claim 15, further comprising a data line and a gate line, located on the base substrate and located in the first region, wherein the data line and the gate line are respectively electrically connected with the pixel circuit, the data line is configured to supply a data signal to the pixel circuit, and the gate line is configured to supply a scan signal to the pixel circuit;
the first metal structure is arranged in a same layer as the data line, and the second metal structure is arranged in a same layer as the gate line.

17. The display panel according to claim 8, wherein in the direction perpendicular to the base substrate, a thickness of the first sub-isolation portion is 1/4 to 1/3 of a thickness of the second sub-isolation portion.

18. A display apparatus, comprising the display panel according to any one of claims 1 to 17.

19. A manufacturing method of a display panel, wherein the display panel comprises a first region, a second region and a third region located between the first region and the second region, the first region is configured to display, the second region is configured to transmit light, and the first region is located on at least one side of the second region;
the manufacturing method comprises:
forming an organic material layer on a base substrate, and patterning the organic material layer, to form an organic layer pattern in the third region;
forming an inorganic material layer on the organic layer pattern, and patterning the inorganic material layer to form a first partition structure in the first region, and form a second partition structure in the third region;
wherein the first partition structure comprises a first isolation portion and a second isolation portion stacked, the first isolation portion is located on a side of the second isolation portion that is away from the base substrate, the first isolation portion comprises a first protrusion portion, the first protrusion portion protrudes relative to an edge of the second isolation portion; the second partition structure comprises a first isolation member and a second isolation member stacked, the first isolation member is located on a side of the second isolation member that is away from the base substrate, the first isolation member comprises a second protrusion portion, and the second protrusion portion protrudes relative to at least a portion of an edge of the second isolation member;
both the first partition structure and the second partition structure are configured to partition at least one layer of the light-emitting functional layer, at least a portion of the inorganic material layer that is located in the first region is patterned to form the first isolation portion, and at least a portion of the inorganic material layer that is located in the third region is patterned to form the first isolation member.

20. The manufacturing method according to claim 19, wherein forming the inorganic material layer on the organic layer pattern, and patterning the inorganic material layer, to form the first partition structure in the first region, and form the second partition structure in the third region, comprises:
patterning the inorganic material layer, to form the first partition structure in the first region, and form an initial partition structure in the third region; wherein the initial partition structure comprises the first isolation member and a second initial isolation member, the first isolation member and the second initial isolation member are stacked, and an edge of the first isolation member protrudes relative to at least a portion of an edge of the second initial isolation member; and
further etching the second initial isolation member in the third region, to form the second partition structure.
